# EUROPEAN PATENT SPECIFICATION

(11) **EP 3 767 762 B1**
(45) Date of publication and mention of the grant of the patent: **30.03.2022**
(21) Application number: 19186184.8
(22) Date of filing: 14.07.2019
(51) Int. Cl.: H01S 5/12, H01S 5/223, H01S 5/30, H01S 5/343

(54) **DISTRIBUTED FEEDBACK LASER DIODE AND METHOD OF MAKING THE SAME**
LASERDIODE MIT VERTEILTER RÜCKKOPPLUNG UND DEREN HERSTELLUNGSVERFAHREN
DIODE LASER À RÉTROACTION DISTRIBUÉE ET PROCÉDÉ DE FABRICATION

(43) Date of publication of application: 20.01.2021
(73) Proprietor: Instytut Wysokich Cisnien Polskiej Akademii Nauk, 01-142 Warszawa (PL)
(72) Inventor: MUZIOL, Grzegorz, 01-466 Warszawa (PL); TURSKI, Henryk, 02-555 Warszawa (PL); SZKUDLAREK, Krzesimir, 01-710 Warszawa (PL); HAJDEL, Mateusz, 81-173 Gdynia (PL); WOLNY, Pawel, 42-700 Lubliniec (PL); SIEKACZ, Marcin, 03-395 Warszawa (PL); SKIERBISZEWSKI, Czeslaw, 05-502 Kamionka (PL)
(74) Representative: Adamczyk, Piotr

(56) References cited:
- WO-A1-2018/113501
- US-B2- 6 724 013
- A. YADAV ET AL: "InGaN distributed feed back laser with sidewall gratings emitting at 42X nm", 2018 INTERNATIONAL CONFERENCE LASER OPTICS (ICLO), 1 June 2018 (2018-06-01), pages 606-606, XP055658335, DOI: 10.1109/LO.2018.8435673 ISBN: 978-1-5386-3612-1

## Description

The subject of the invention is a distributed feedback laser diode (DFB LD), made of group III nitrides and having a single-mode emission spectrum with a wavelength in the 0.370 to 0.540 µm range and a method for producing the said laser diode.

Conventional blue-light laser diodes made of group III nitrides described, for example, in JP3160914B2, JPH05343741A, EP0599224B2, US6791103B2 and WO2000048254A1, are produced through MOVPE, i.e. Metal Organic Vapor Phase Epitaxy. EP1787366B1 discloses an alternative method of producing such laser diodes using PAMBE (Plasma-Assisted Molecular Beam Epitaxy). Such laser diodes have a multi-mode emission spectrum.

DFB laser diodes are laser light sources with a single-mode emission spectrum and very high side-mode suppression ratio, and are used in communication, gas detection and atomic clocks. DFB laser diodes have been known since the 1970s. Currently, DFB laser diodes are available in the λ=0.760-16 µm spectral range and demonstrate very good performance. However, there are no DFB laser diodes on the market operating in the visible electromagnetic spectrum, even though conventional laser diodes based on group III nitrides emit light in the λ=0.370-0.540 µm range. However, the use of nitride laser diodes for the fabrication of DFB instruments is burdened with such severe technological limitations that attempts to manufacture DFB laser diodes based on group III nitrides have been unsuccessful.

DFB laser diodes are produced by creating a periodic refractive index contrast area in the light propagation direction. The basic technology for creating such a contrast is to interrupt the epitaxial growth of the laser structure after deposition of an active area, create grooves on the surface and to repeat epitaxial growth with a material with a different refractive index. Such a solution is disclosed in US4023993A. This method is used commercially in the manufacture of DFB laser diodes from group III arsenides and group III phosphides. DFB laser diodes based on group III nitrides and produced by the above method were disclosed in US6285698B, US6574256B, US7781796B and US7804882B. However, S.Masui et al. in "CW Operation of the First-Order AlInGaN 405 nm Distributed Feedback Laser Diodes" [Jpn. J.Appl. Phys.45, L1223-L1225 (2006)] show that in the case of group III nitrides, the side-mode attenuation coefficients are below values allowing such instruments to be used in industrial applications. This stems from material limitations of group III nitrides, i.e. from the low refractive index contrast between the materials (Al,In)GaN and from the significant mismatch of solid (Al,In)GaN material networks.

In US6671306B1 a DFB laser diode is disclosed with a periodic refractive index contrast area located at the sides of the mesa. It is obtained by applying, after epitaxial growth, a material with a different refractive index, e.g. a metal, such a method does not require high conductivity of the layers at the top of the laser diode. In this manner the material applied is optically coupled with the light propagating in the laser structure. JH Kang et al. in their work "DFB Laser Diodes Based on GaN Using 10th Order Laterally Coupled Surface Gratings" [IEEE Photonics Technology Letters 30, 231-234 (2018)] describe the application of this method to produce DFB lasers based on group III nitrides, but the obtained side mode suppression ratios were low and comparable to those of the traditional method.

A. Yadav et al. "InGaN distributed feed back laser with sidewall gratings emitting at 42X nm", Proceedings of 2018 INTERNATIONAL CONFERENCE LASER OPTICS (ICLO), 1 June 2018, pages 606-606 disclose a distributed feedback laser diode in accordance with the preamble of claims 1 and 8.

DFB laser diodes are also disclosed in US4722092A and US4777148A.

When such a diode is produced, a periodic recessed structure (a diffraction grating) is etched on top of the mesa and filled with a material with a refractive index different from the refractive index of the material in the epitaxial layers. This requires the layers under the diffraction grating to assure high electrical conductivity, since the metallisation needs to be moved to the sides of the mesa. However, this solution has not been used in laser diodes based on group III nitrides due to the low conductivity of p-type layers.

WO 2018/113501 A1 discloses a DFB laser with an upper cladding layer that comprises a buried tunnel junction and a high refractive index layer forming a ridge waveguide. A Bragg grating is etched on the surface of the ridge waveguide.

The goal of the invention was to obtain a distributed feedback laser diode having a single-mode emission spectrum with a wavelength in 0.370 to 0.540 µm range and a high side mode attenuation coefficient.

This goal is fulfilled by a laser diode according to the invention, comprising a layered structure placed on a crystalline substrate, comprising a lower *n*-type optical cladding, a lower waveguide, an active area, an upper waveguide, an electron blocking layer and an upper *p*-type optical cladding. The layered diode structure has on top a mesa with a periodic refractive index contrast area containing periodically distributed longitudinal grooves. In the diode according to the invention the components of its layered structure are made of group III nitrides. In the area of the mesa, the upper *p*-type optical cladding features a tunnel junction covered from the top by an *n*-type current spreading layer. The longitudinal grooves of the periodic refractive index contrast area are distributed parallel in respect to one another in the outer surface of the *n*-type current spreading layer and run through the entire width of the mesa.

In one of the variants of the laser diode according to the invention, the distance between adjacent periodically distributed longitudinal grooves is 50 to 500 nm.

In another variant of the laser diode according to the invention, the depth of the periodically distributed longitudinal grooves is essentially constant and not greater than the thickness of the n-type current spreading layer and is in the range of 20 to 150 nm.

In next variant the laser diode according to the invention, the width of the periodically distributed longitudinal grooves is essentially constant and ranges from 25 to 250 nm.

In next variant of the laser diode according to the invention, the tunnel junction is an In₁₋ₓGaₓN indium gallium nitride alloy layer containing a first sub-layer doped with magnesium and adjacent to the *p*-type optical cladding and a second sub-layer doped with silicon and adjacent to the n-type current spreading layer.

In another variant of the laser diode according to the invention, the tunnel junction is a doped ln₁₋ₓGaₓN alloy layer, where the *x* ranges from 0.02 to 0.20. The doping level of the first sub-layer of the tunnel junction ranges from 3 × 10¹⁹cm⁻³ to 3 × 10²⁰cm⁻³, and the doping level of the second sub-layer of the tunnel junction ranges from 1 × 10²⁰cm⁻³ to 9 × 10²⁰cm⁻³.

In yet another variant of the laser diode according to the invention, the total thickness of the layer constituting the tunnel junction ranges from 20 to 70 nm, with the thickness of its first sub-layer constituting 20 to 80% of this layer's total thickness.

The method according to the invention consists in producing a layered structure from group III nitrides on a crystalline substrate through a process of plasma-assisted molecular beam epitaxy (PAMBE). The produced layer structure comprises a lower *n*-type optical cladding, a lower waveguide, an active area, an upper waveguide, an electron blocking layer and an upper *p*-type optical cladding. A mesa is formed on top of the produced layered structure, in which a periodic refractive index contrast area is formed with periodically distributed longitudinal grooves. The method according to the invention is characterised in that after deposition of the upper *p*-type optical cladding, the tunnel junction layer is deposited through epitaxy, followed by the formation of a mesa reaching towards the crystalline substrate up to the upper *p*-type optical cladding. On the formed mesa, an *n*-type current spreading layer is deposited through epitaxy, and then a periodic refractive index contrast area is made on its outer surface, in the form of periodically spaced and parallel longitudinal grooves running through the entire width of the mesa.

In one of variants of the method according to the invention, the periodically distributed longitudinal grooves are made at a distance of 50 to 500 nm from an adjacent longitudinal groove. The depth of these grooves is essentially constant and not greater than the thickness of the n-type current spreading layer, and is in the 20 to 150 nm range. The width of the grooves is also essentially constant and ranges from 25 to 250 nm.

In another variant of the method according to the invention, the tunnel junction layer is made of an In₁₋ₓGaₓN indium gallium nitride alloy, where the *x* ranges from 0.02 to 0.20, with a first sub-layer of the tunnel junction deposited from this alloy doped with magnesium and on it a second sub-layer deposited from the same alloy but doped with silicon.

In another variant of the method according to the invention the total thickness of the layer constituting the tunnel junction ranges from 5 to 70 nm, with the thickness of its first sub-layer constituting 20 to 80% of this layer's total thickness. In next variant of the method according to the invention, the tunnel junction layer is deposited at a temperature of 600°C to 700°C.

In next variant of the method according to the invention, the *n*-type current spreading layer is deposited at a temperature of 680°C to 780°C.

In next variant of the method according to the invention, the nitrogen for the epitaxial growing of the layered structure is provided in the form of plasma induced by a power supply generating 350 to 500 W of power, with the nitrogen flow ranging from 1 to 3 millilitres per minute.

In yet another variant of the method according to the invention, the epitaxial growth of the layered structure is conducted under metal-rich conditions.

In the diode according to the invention, the longitudinal grooves etched in the mesa, within the periodic refractive index contrast area, form a diffraction grating covering the entire mesa area, thanks to which a high laser optical mode feedback to the grating and very high side mode suppression ratio necessary for communication applications is obtained. The invention overcomes the commonly held belief among specialists that the fabrication of a DFB laser diode based on group III nitrides, in which the above-mentioned diffraction grating covers the entire surface of the mesa, is unachievable due to it being impossible to move the metallisation outside the mesa area, since the conductivity of *p*-type layers is low and would result in unacceptably high operating voltages. Unexpectedly, it transpired that the addition of a tunnel junction to the known DFB laser structure allows placement of the metallisation outside the mesa area. The tunnel junction is used in such a system to change the conductivity from *p*-type to *n*-type, which demonstrates high conductivity. Unexpectedly, it emerged that removing the tunnel junction layer everywhere outside the mesa area allows the current flow to be directed in such a manner that it feeds only the active area directly under the mesa. As a result, all the generated light is coupled to the diffraction grating located on the mesa surface. The aforementioned high optical mode feedback with the described diffraction grating enables etching of shallow longitudinal grooves, which significantly simplifies the DFB laser diode fabrication process and results in high homogeneity of devices on the whole crystal, which results in high yields, significantly lowering production costs.

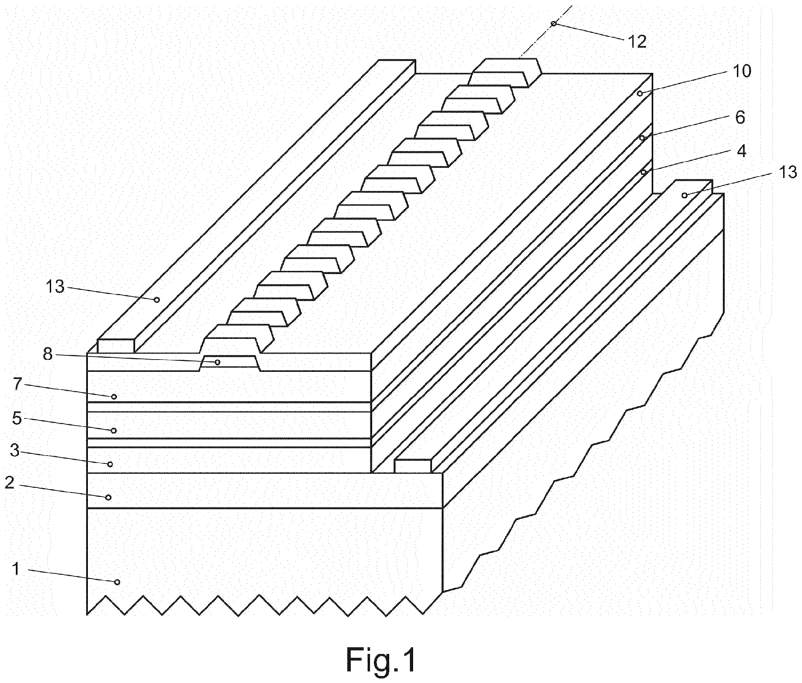

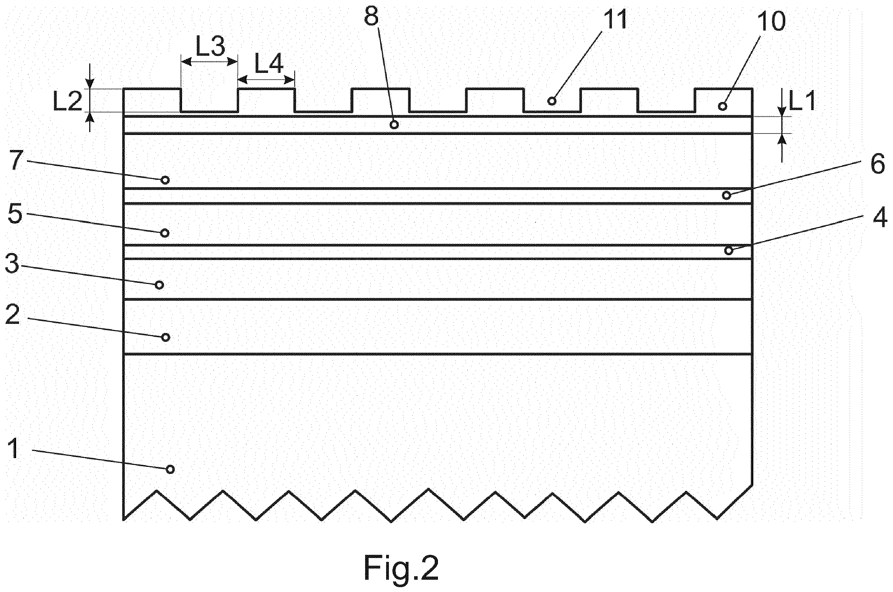

The invention is illustrated by an exemplary embodiment in the drawing, in which Fig.1 shows a schematic of the laser diode's structure according to the invention in an axonometric view, and Fig.2 shows the same structure in a vertical section along the mesa's peak. Fig.3 shows the light-current characteristics, and Fig.4 shows the voltage-current characteristics of the laser diode according to the invention described below. Fig.5 shows the spectral characteristics of this laser diode.

The example laser diode described below was made using the PAMBE growth method. Substrate 1, 350 µm thick, made of gallium nitride was outgassed in preliminary chamber at 150°C for 1.5 hours. The outgassing of the substrate 1 was continued for 30 minutes in the preparatory chamber at 650°C. The outgassed substrate 1 was transferred to the growth chamber. Layer epitaxy was performed in metal-rich conditions. Nitrogen used for growth was supplied in the form of plasma induced by a power supply generating 420 W of power, with a nitrogen flow of 2 ml/min. At a temperature of 730°C, a lower optical cladding 2 (*n-*type) was first made with a thickness of 1 µm from Al_{0.06}Ga_{0.94}N doped with 1×10¹⁸ cm⁻³ of silicon. Then, the growth temperature was lowered to 650°C and subsequently a lower waveguide 3 in the form of an In_{0.08}Ga_{0.92}N layer with a thickness of 80 nm, an active area 4, composed of In_{0.17}Ga_{0.83}N multiquantum wells with a 3 nm well width, an upper waveguide 5 of an In_{0.08}Ga_{0.92}N layer with a thickness of 60 nm and an electron blocking layer 6 with a thickness of 20 nm from Al_{0.15}Ga_{0.85}N, doped with 3×10¹⁹ cm⁻³ of magnesium, were fabricated. In the active area 4 there were three multiquantum wells. The temperature in the growth chamber was then raised to 730°C and the upper optical cladding 7 (*p*-type), 70 nm thick, was produced from GaN doped with 1×10¹⁸cm⁻³ of magnesium. After the temperature in the growth chamber was lowered to 650°C, a tunnel junction 8 was produced in the form of a layer with an L1 thickness of 10 nm of a doped In_{0.15}Ga_{0.85}N alloy. The tunnel junction 8 layer was formed of a first sub-layer doped with 1×10²⁰cm⁻³ of magnesium and of a second sub-layer doped with 5×10²⁰cm⁻³ of silicon. Both sub-layers were of the same thickness. The epitaxially formed layered structure (1 to 8) was subjected to photolithography and RIE (Reactive Ion Etching) to form a 3 µm wide mesa.

The distances between successive mesas were 300 µm. The mesa was etched to a depth of 120 nm, i.e. to the level of the upper optical cladding 7. On the formed mesa, in the same growth chamber of the PAMBE reactor, at a temperature of 730°C, epitaxy was used to create a current spreading layer 10 with a thickness of 150 nm from GaN doped with 2×10¹⁹cm⁻³ of silicon. The fabricated layered structure (1 to 10) was then removed from the growth chamber and subjected to electron lithography and RIE to produce in the current distribution layer 10 longitudinal grooves 11 running parallel to each other and perpendicular to the longitudinal axis 12 of the mesa.

The longitudinal grooves 11 formed a periodic refractive index contrast area at the top of the mesa, resulting from the difference between the refractive index of the air and the material forming the current distribution layer 10. The created grooves 11 had a depth L2 of 100 nm. The width L3 of the grooves 11 was 226 nm. The distance L4 between adjacent grooves 11 was 226 nm. Subsequently, the laser structure with grooves (from 1 to 11) was reduced from the substrate 1 side to a thickness of 120 µm. In the next step, metallisation strips 13 from Ni/Au with a thickness of 25 nm/75 nm were applied in a known manner in the area outside of the mesa.

At the end, the structure was divided into individual chips measuring 120 × 300 × 1000 µm and encapsulated.

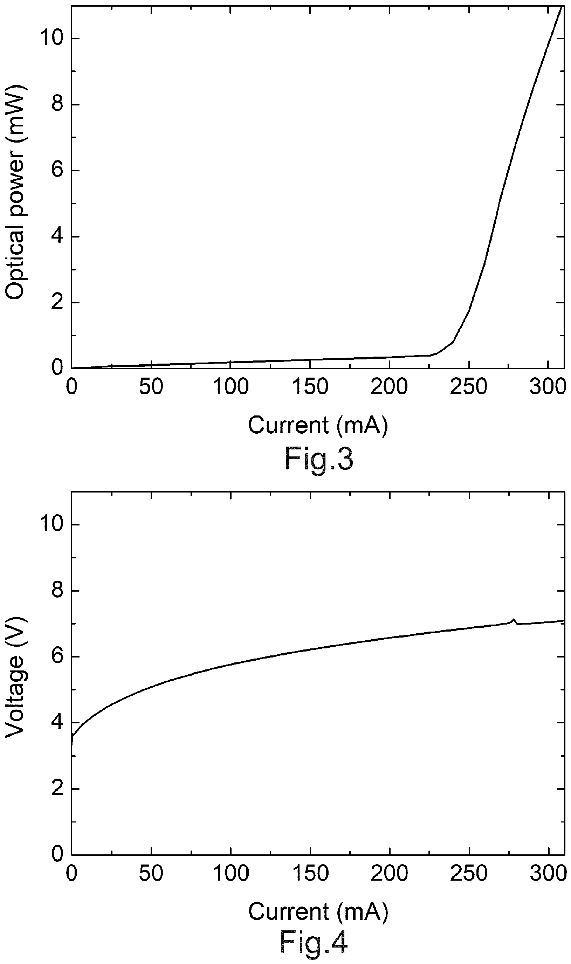

As shown in Fig.3, the laser diode described above operates continuously with a threshold current of 230 mA. Optical power of 10 mW, sufficient for practical applications, is obtained at a current of 300 mA. Fig.4 shows that the voltage at the lasing threshold is 6.8 V and 7.1 V at the operating current allowing 10 mW optical power to be reached. Such a low operating voltage, despite placement of the metallisation outside the mesa area, results from the use of a tunnel junction changing the conductivity from *p*-type to *n*-type.

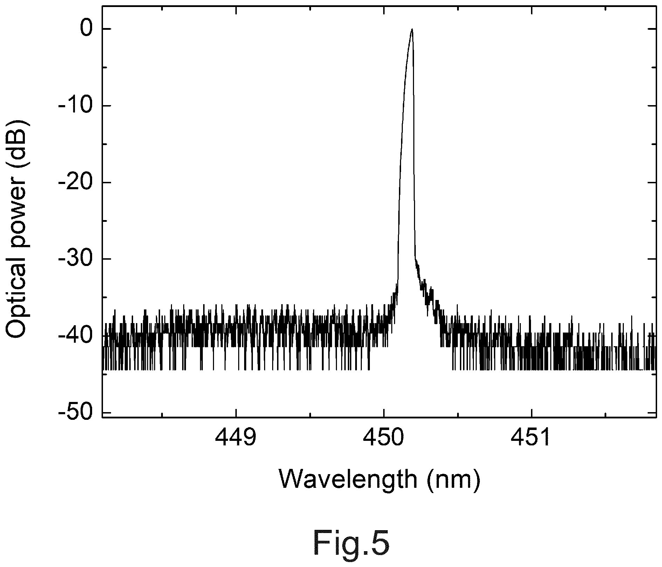

Fig.5 demonstrates that a single-mode emission spectrum with a wavelength λ=0.450 µm was obtained, with a side mode suppression ratio of 35 dB, which indicates high light feedback with the periodic photonic structure at the top of the mesa.

## Claims

1. A distributed feedback laser diode, comprising a layered structure applied to a crystalline substrate (1) and including a lower *n*-type optical cladding (2), a lower waveguide (3), an active area (4), an upper waveguide (5), an electron blocking layer (6) and an upper p-type optical cladding (7), and having a mesa on top with a periodic refractive index contrast area comprising periodically distributed longitudinal grooves (11), wherein the constituent elements of the layered structure are made of group III nitrides, **characterized in that**
the upper *p*-type optical cladding(7) has, in the area of the mesa, a tunnel junction (8) covered from the top by an *n*-type current spreading layer (10), wherein the longitudinal grooves (11) of the periodic refractive index contrast area are distributed parallel to one another in the outer surface of the *n*-type current spreading layer (10) and running through the entire width of the mesa.

2. The laser diode according to claim 1, **characterised in that** the distance (L4) between adjacent periodically spaced longitudinal grooves (11) is 50 to 500 nm.

3. The laser diode according to claim 1 or 2, **characterised in that** the depth (L2) of the periodically distributed longitudinal grooves (11) is essentially constant and not greater than the thickness of the *n*-type current spreading layer (10) and is in the 20 to 150 nm range.

4. The laser diode according to claim 1 or 2 or 3, **characterised in that** the width (L3) of the periodically distributed longitudinal grooves (11) is essentially constant and ranges from 25 to 250 nm.

5. The laser diode according to claim 1, **characterised in that** the tunnel junction is an In₁₋ₓGaₓN indium gallium nitride alloy layer comprising a first sub-layer doped with magnesium and adjacent to the *p*-type optical cladding (7) and a second sub-layer doped with silicon and adjacent to the *n*-type current spreading layer (10).

6. The laser diode according to one of the claims 1 to 5, **characterised in that** the tunnel junction (8) is a doped In₁₋ₓGaₓN alloy layer, where the *x* ranges from 0.02 to 0.20, with the doping level of the first sub-layer of the tunnel junction (8) ranging from 3 × 10¹⁹cm⁻³ to 3 × 10²⁰cm⁻³, and the doping level of the second sub-layer of the tunnel junction (8) ranging from 1 × 10²⁰cm⁻³ to 9 × 10²⁰cm⁻³.

7. The diode according to claim 5 or 6, **characterised in that** the total thickness (L1) of the layer constituting the tunnel junction (8) is between 5 and 30 nm, with the thickness of its first sub-layer constituting 20 to 80% of the total thickness (L1) of this layer.

8. A method of producing a distributed feedback laser diode, which comprises forming a layered structure of a laser diode from group III nitrides on a crystalline substrate (1) through a process of plasma-assisted molecular beam epitaxy (PAMBE), with the said layer structure comprising a lower *n*-type optical cladding (2), a lower waveguide (3), an active area (4), an upper waveguide (5), an electron blocking layer (6), an upper *p*-type optical cladding (7), with a mesa then formed on top of the layered structure, in which a periodic refractive index contrast area is made with periodically distributed longitudinal grooves (11), **characterised in that** after deposition of the upper *p*-type optical cladding (7), the tunnel junction layer (8) is epitaxially deposited, then a mesa is formed extending towards the crystalline substrate (1) to the upper *p*-type optical cladding (7), on the formed mesa an *n*-type current spreading layer (10) is formed through epitaxy, and then a periodic refractive index contrast area is made on its external surface in the form of periodically distributed and parallel longitudinal grooves (11) running across the entire width of the mesa.

9. The method according to claim 8, **characterised in that** the periodically distributed longitudinal grooves (11) are made at a distance (L4) of 50 to 500 nm from a neighbouring longitudinal groove (11), with the depth (L2) of these grooves (11) essentially constant and not greater than the thickness of the *n*-type current spreading layer (10) and being in the 20 to 150 nm range, while the width (L3) of these grooves (11) is also essentially constant and ranges from 25 to 250 nm.

10. The method according to claim 8 or 9, **characterised in that** the layer constituting the tunnel junction (8) is made of an In₁₋ₓGaₓN gallium indium nitride alloy, where the *x* ranges from 0.02 to 0.20, with a first sub-layer of the tunnel junction placed from this alloy doped with magnesium, and on it a second sub-layer placed from the same alloy applied but doped with silicon.

11. The method according to claim 10, **characterised in that** the total thickness (L1) of the layer constituting the tunnel junction (8) is between 5 and 30 nm, with the thickness of its first sub-layer constituting 20 to 80% of this layer's total thickness (L1).

12. The method according to claim 10 or 11, **characterised in that** the tunnel junction (8) layer is deposited at a temperature of 600°C to 700°C.

13. The method according to one of the claims 10 to 12, **characterised in that** the *n*-type current spreading layer (10) is deposited at a temperature of 680°C to 780°C.

14. The method according to one of the claims 8 to 13, **characterised in that** the nitrogen for epitaxial growth of the layer structure is supplied in the form of plasma induced by a power supply generating 350 to 500 W of power, with the nitrogen flow ranging from 1 to 3 millilitres per minute.

15. The method according to one of the claims 8 to 14, **characterised in that** the epitaxial growth of the layered structure is performed under metal-rich conditions.

## Patentansprüche

1. Eine Laserdiode mit verteilter Rückkopplung, die aus einer auf einem kristallinen Substrat aufgebrachten Schichtstruktur besteht (1) einschließlich einer unteren optischen *n*-Typ-Schicht (2), eines unteren Wellenleiters (3), eines aktiven Bereichs (4), eines oberen Wellenleiters (5), einer Elektronensperrschicht (6) und einer oberen optischen *p*-Typ-Schicht (7), und mit einer Mesa oben mit einem periodischen Brechungsindex-Kontrastbereich, der aus periodisch verteilten Längsrillen besteht (11), **wobei** die Bestandteile der Schichtstruktur aus Gruppe-III-Nitriden bestehen, **dadurch gekennzeichnet, dass** der obere optische *p*-Typ-Schicht (7) im Bereich der Mesa einen Tunnelkontakt (8) hat, der von oben mit einer *n*-Typ-Stromausbreitungsschicht bedeckt ist (10), in dem die Längsrillen (11) des periodischen Brechungsindex-Kontrastbereichs parallel zueinander in der Außenfläche der *n*-Typ-Stromausbreitungsschicht (10) verteilt sind über die gesamte Breite der Mesa verlaufen.

2. Die Laserdiode nach Anspruch 1, **dadurch gekennzeichnet, dass** der Abstand (L4) zwischen benachbarten, periodisch beabstandeten Längsrillen (11) 50 bis 500 nm beträgt.

3. Die Laserdiode nach Anspruch 1 oder 2, **dadurch gekennzeichnet, dass** die Tiefe (L2) der periodisch verteilten Längsrillen (11) im Wesentlichen konstant und nicht größer als die Dicke der *n*-Typ-Stromausbreitungsschicht (10) ist und im Bereich von 20 bis 150 nm liegt.

4. Die Laserdiode nach Anspruch 1 oder 2 oder 3, **dadurch gekennzeichnet, dass** die Breite (L3) der periodisch verteilten Längsrillen (11) im Wesentlichen konstant ist und im Bereich von 25 bis 250 nm liegt.

5. Die Laserdiode nach Anspruch 1, **dadurch gekennzeichnet, dass** der Tunnelkontakt eine In₁₋ₓGaₓN-Indium-Gallium-Nitrid-Legierungsschicht ist, die aus einer ersten, mit Magnesium dotierten und an die optische *p*-Typ-Schicht (7) angrenzenden Teilschicht und einer zweiten, mit Silizium dotierten Teilschicht, die an die *n*-Typ-Stromausbreitungsschicht (10) angrenzt, besteht.

6. Die Laserdiode nach einem der Ansprüche 1 bis 5, **dadurch gekennzeichnet, dass** der Tunnelkontakt (8) eine dotierte In₁₋ₓGaₓN-Legierungsschicht ist, wobei *x* im Bereich von 0,02 bis 0,20 liegt, mit dem Dotierungsniveau der ersten Teilschicht des Tunnelkontakts (8) im Bereich von 3 × 10¹⁹cm⁻³ bis 3 × 10²⁰cm⁻³ und mit dem Dotierungsniveau der zweiten Teilschicht des Tunnelkontakts (8) im Bereich von 1 × 10²⁰cm⁻³ bis 9 × 10²⁰cm⁻³.

7. Die Laserdiode nach Anspruch 5 oder 6, **dadurch gekennzeichnet, dass** die Gesamtdicke (L1) der Schicht, die den Tunnelkontakt (8) bildet, zwischen 5 und 30 nm liegt, wobei die Dicke der ersten Tunnelkontakt-Teilschicht 20 bis 80 % der Gesamtdicke (L1) dieser Schicht ausmacht.

8. Ein Verfahren zum Herstellen einer Laserdiode mit verteilter Rückkopplung, die eine Schichtstruktur bildet und aus einer Laserdiode aus Gruppe-III-Nitriden auf einem kristallinen Substrat (1) besteht, durch einen Prozess der plasmaunterstützten Molekularstrahlepitaxie (PAMBE), wobei die oben genannte Schichtstruktur eine untere optische *n*-Typ-Schicht (2), einen unteren Wellenleiter (3), einen aktiven Bereich (4), einen oberen Wellenleiter (5), eine Elektronensperrschicht (6), und eine obere optische *p*-Typ-Schicht (7) umfasst, mit einer dann oben auf der Schichtstruktur gebildeten Mesa, in der ein periodischer Brechungsindex-Kontrastbereich mit periodisch verteilten Längsrillen (11) hergestellt wird, **dadurch gekennzeichnet, dass** nachdem die obere optische *p*-Typ-Schicht (7) aufgebracht wurde, wird die Tunnelkontaktschicht (8) epitaktisch aufgebracht, dann wird eine Mesa gebildet, das sich in Richtung des kristallinen Substrats (1) zu der oberen optischen *p*-Typ-Schicht (7) erstreckt, auf der gebildeten Mesa wird durch Epitaxie eine *n*-Typ-Stromausbreitungsschicht (10) gebildet, und dann wird auf seiner Außenfläche ein periodischer Brechungsindex-Kontrastbereich in Form von periodisch verteilten und parallelen Längsrillen (11) hergestellt, die über die gesamte Breite der Mesa verlaufen.

9. Das Verfahren nach Anspruch 8, **dadurch gekennzeichnet, dass** die periodisch verteilten Längsrillen (11) in einem Abstand (L4) von 50 bis 500 nm zwischen den benachbarten Längsrillen (11) eingebracht werden, wobei die Tiefe (L2) dieser Rillen (11) im Wesentlichen konstant und nicht größer als die Dicke der *n*-Typ-Stromausbreitungsschicht (10) ist und im Bereich von 20 bis 150 nm liegt, während die Breite (L3) dieser Rillen (11) ist ebenfalls im Wesentlichen konstant und reicht von 25 bis 250 nm.

10. Das Verfahren nach Anspruch 8 oder 9, **dadurch gekennzeichnet, dass** die den Tunnelkontakt (8) bildende Schicht aus einer In₁₋ₓGaₓN-Gallium-Indium-Nitrid-Legierung hergestellt wird, wobei *x* im Bereich von 0,02 bis 0,20 liegt, wobei zunächst eine erste Tunnelkontakt-Teilschicht aus dieser mit Magnesium dotierten Legierung aufgebracht wird und darauf eine zweite Teilschicht aus derselben, jedoch mit Silizium dotierten, Legierung aufgebracht wird.

11. Das Verfahren nach Anspruch 10, **dadurch gekennzeichnet, dass** die Gesamtdicke (L1) der den Tunnelkontakt (8) bildenden Schicht zwischen 5 und 30 nm liegt, wobei die Dicke der ersten Tunnelkontakt-Teilschicht 20 bis 80 % der Gesamtdicke (L1) dieser Schicht ausmacht.

12. Das Verfahren nach Anspruch 10 oder 11, **dadurch gekennzeichnet, dass** die Tunnelkontaktschicht (8) bei einer Temperatur von 600 °C bis 700 °C aufgebracht wird.

13. Das Verfahren nach einem der Ansprüche 10 bis 12, **dadurch gekennzeichnet, dass** die *n*-Typ-Stromausbreitungsschicht (10) bei einer Temperatur von 680 °C bis 780 °C aufgebracht wird.

14. Das Verfahren nach einem der Ansprüche 8 bis 13, **dadurch gekennzeichnet, dass** der Stickstoff für das epitaxiale Wachstum der Schichtstruktur in Form von Plasma zugeführt wird, das durch eine Energieversorgung induziert wird, die 350 bis 500 W Leistung erzeugt, wobei der Stickstofffluss im Bereich von 1 bis 3 Milliliter pro Minute liegt.

15. Das Verfahren nach einem der Ansprüche 8 bis 14, **dadurch gekennzeichnet, dass** das epitaxiale Wachstum der Schichtstruktur unter metallreichen Bedingungen durchgeführt wird.

## Revendications

1. Une diode laser à rétroaction distribuée, constituée d'une structure en couches déposée sur un support cristallin (1) et contenant une couverture optique inférieure de type *n* (2), un guide d'onde inférieur (3), une zone active (4), un guide d'onde supérieur (5), une couche bloquant les électrons (6) et une couverture optique supérieure de type *p* (7) et ayant une mésa sur le dessus avec une zone de contraste d'indice de réfraction périodique contenant des cavités longitudinales réparties périodiquement (11), **caractérisée en ce que** les composants de la structure de couche sont constitués de nitrures de métaux du groupe III, **caractérisés en ce que** la couverture optique supérieure de type *p* (7) contient dans la zone de la mésa une jonction à effet tunnel (8) recouverte par le dessus d'une couche de diffusion du courant de type *n* (10), **caractérisée en ce que** les enfoncements longitudinales (11) de la zone périodique du contraste de l'indice de réfraction sont disposées parallèlement les unes aux autres sur la surface extérieure de la couche de dissipation du courant de type *n* (10) et s'étendent sur toute la largeur de la mésa.

2. La diode laser selon la revendication 1, **caractérisée en ce que** la distance (L4) entre les enfoncements longitudinaux adjacents périodiquement espacés (11) est de 50 à 500 nm.

3. La diode laser selon la revendication 1 ou 2, **caractérisée en ce que** la profondeur (L2) des enfoncements longitudinaux répartis périodiquement (11) est principalement constante et non supérieure à l'épaisseur de la couche de dissipation du courant de type *n* (10) et est comprise dans une étendue de 20 à 150 nm.

4. La diode laser selon la revendication 1 ou 2 ou 3, **caractérisée en ce que** la largeur (L3) des enfoncements longitudinaux périodiquement répartis (11) est sensiblement constante et est comprise dans une étendue 25 à 250 nm.

5. La diode laser selon la revendication 1, **caractérisée en ce que** la jonction à effet tunnel constitue une couche d'alliage nitrure-gallium-indium In₁₋ₓGaₓN, constituée d'une première sous-couche avec un alliage de magnésium et adjacente à la couverture optique de type *p* (7) et d'une deuxième sous-couche avec un alliage de silicium et adjacente à la couche dissipant le courant de type *n* (10).

6. La diode laser selon l'une des revendications de 1 à 5, **caractérisée en ce que** la jonction à effet tunnel (8) est une couche du mélange de l'alliage In₁₋ₓGaₓN, où *x* est compris entre 0,02 et 0,20, le niveau du mélange de la première sous-couche de la jonction à effet tunnel (8) ) est de 3 × 10¹⁹cm⁻³ do 3 × 10²⁰cm⁻³, tandis que le niveau du mélange de la deuxième sous-couche de la jonction à effet tunnel (8) est de 1 × 10²⁰cm⁻³ do 9 × 10²⁰cm⁻³.

7. La diode selon la revendication 5 ou 6, **caractérisée en ce que** l'épaisseur totale (L1) de la couche constituant la jonction à effet tunnel (8) est de 5 à 30 nm, tandis que l'épaisseur de sa première sous-couche étant de 20 à 80 % de l'épaisseur totale (L1 ) de cette couche.

8. Un procédé de réalisation d'une diode laser à rétroaction répartie, qui consiste en une création d'une structure en couches d'une diode laser à partir de nitrures de métaux du groupe III sur un support cristallin (1) par le procédé de croissance épitaxiale à partir de faisceaux moléculaires par plasma d'azote (PAMBE), tandis que la structure mentionnée se compose d'une couverture optique inférieure de type *n* (2), d'un guide d'ondes inférieur (3), d'une zone active (4), d'un guide d'ondes supérieur (5), d'une couche de blocage d'électrons (6), d'une couverture optique supérieure de type *p* (7), tandis que sur le dessus de la structure en couches, une mésa est ensuite formée, dans laquelle une zone de contraste d'indice de réfraction périodique avec des enfoncements longitudinaux répartis périodiquement (11) est formée, **caractérisé en ce qu'**après l'application de la couverture supérieure de type *p* (7), la couche de jonction à effet tunnel (8) est appliquée par épitaxie, après quoi une mésa est formée s'étendant dans la direction du support cristallin (1) vers la couverture optique supérieure de type *p* (7), sur la couche crée de dispersion du courant de type *n* (10) est formée par épitaxie, ensuite une zone de contraste d'indice de réfraction périodique est créée sur sa surface extérieure sous forme d'enfoncements longitudinaux parallèles et répartis périodiquement (11) s'étendant sur toute la largeur de la mésa.

9. Le procédé selon la revendication 8, **caractérisé en ce que** les enfoncements longitudinaux répartis périodiquement (11) sont réalisés à une distance (L4) de 50 à 500 nm de l'enfoncement longitudinal adjacent (11), tandis que la profondeur (L2) de ces enfoncements (11) est principalement constante et pas plus grande que l'épaisseur de la couche de dissipation du courant de type *n* (10) et est comprise entre 20 et 150 nm, tandis que la largeur (L3) de ces puits (11) est également sensiblement constante et est de 25 à 250 nm.

10. Le procédé selon la revendication 8 ou 9, **caractérisé en ce que** la couche constituant le joint à effet tunnel (8) est constituée d'un alliage de nitrure de gallium-indium In₁₋ₓGaₓN, où *x* est compris entre 0,02 et 0,20, dans lequel la première sous-couche du joint est appliquée en premier à partir de cet alliage au mélange de magnésium, et dessus une seconde sous-couche du même alliage, mais au mélange de silicium, est appliquée.

11. Le procédé selon la revendication 10, **caractérisée en ce que** l'épaisseur totale (L1) de la couche constituant la jonction à effet tunnel (8) est de 5 à 30 nm, tandis que l'épaisseur de sa première sous-couche étant de 20 à 80% de l'épaisseur totale (L1) de cette couche.

12. Le procédé selon la revendication 10 ou 11, **caractérisé en ce que** la couche du joint à effet tunnel (8) est appliquée dans une température de 600°C à 700°C.

13. Le procédé selon l'une des revendications de 10 à 12, **caractérisé en ce que** la couche de dispersion du courant de type *n* (10) est appliquée dans une température de 680°C à 780°C.

14. Le procédé selon l'une des revendications 8 à 13, **caractérisé en ce que** l'azote pour la croissance épitaxiale de la structure en couches est apporté sous la forme d'un plasma induit par une alimentation générant une puissance de 350 à 500 W, avec un flux d'azote de 1 à 3 millilitres par minute.

15. Le procédé selon une des revendications de 8 à 14, **caractérisé en ce que** la croissance épitaxiale de la structure en couches est réalisée dans des conditions riches en métal.
